# EUROPÄISCHE PATENTSCHRIFT

(11) **EP 3 050 998 B1**
(45) Veröffentlichungstag und Bekanntmachung des Hinweises auf die Patenterteilung: **27.03.2019**
(21) Anmeldenummer: 15152816.3
(22) Anmeldetag: 28.01.2015
(51) Int. Cl.: C23C 14/02, C23C 16/02, C22F 1/18

(54) **Bauteil mit Schutzschicht und Verfahren zur Herstellung desselben**
Component with protective layer and method for producing the same
Composant doté d'une couche de protection et son procédé de fabrication

(43) Veröffentlichungstag der Anmeldung: 03.08.2016
(73) Patentinhaber: MTU Aero Engines AG, 80995 München (DE)
(72) Erfinder: Haltrich, Marc, 83059 Kolbermoor (DE); Smarsly, Wilfried, 81669 München (DE)

(56) Entgegenhaltungen:
- DE-A1- 3 426 201
- DE-A1-102011 006 294
- DE-T2- 69 432 642
- JP-A- S5 698 470
- US-A1- 2014 369 822

## Beschreibung

### HINTERGRUND DER ERFINDUNG

### GEBIET DER ERFINDUNG

Die vorliegende Erfindung betrifft ein Verfahren zur Herstellung eines Bauteils mit einer Beschichtung sowie ein entsprechendes Bauteil mit einer Beschichtung.

### STAND DER TECHNIK

Bauteile, die in extremen Umgebungsbedingungen, wie beispielsweise in korrosiven Medien oder bei hohen Temperaturen eingesetzt werden, müssen vor entsprechenden Korrosions- und Oxidationsangriffen geschützt werden. Hierzu werden häufig Beschichtungen eingesetzt, die an dem Bauteil angebracht sind. Dies gilt insbesondere auch für Bauteile von Strömungsmaschinen, wie stationären Gasturbinen oder Flugtriebwerken, die hohen Temperaturen und aggressiven Atmosphären ausgesetzt sind. Neben Angriffen durch korrosive Medien und durch Oxidation sind derartige Bauteile häufig auch abrasiven Partikeln, wie Sand ausgesetzt, sodass insbesondere Bauteile in Flugtriebwerken komplexe Schutzbeschichtungen gegen Oxidation, Korrosion und/oder Abrasion und Verschleiß aufweisen.

Neben den Angriffen durch Oxidation, Korrosion und/oder Abrasion und Verschleiß werden derartige Bauteile jedoch zusätzlich hohen mechanischen Belastungen ausgesetzt, die nicht nur durch starke Temperaturwechsel bedingt sind, sondern auch aus Belastungsschwankungen während des Betriebs resultieren, da beispielsweise Flugtriebwerke bei Flugzeugstarts Spitzenleistungen erbringen müssen, während im Reiseflug die Belastungen deutlich verringert sind. Durch die unterschiedlichen mechanischen Belastungen wird aber auch die Haftfestigkeit von Beschichtungen starken Belastungen ausgesetzt, da unterschiedliche Dehnungen des Grundwerkstoffs im Bauteil und des Beschichtungswerkstoffs zu Belastungen an der Grenzfläche zwischen Grundwerkstoff des Bauteils und Beschichtung führen können.

Auch kann es vorkommen, dass Beschichtungen, insbesondere Beschichtungen aus einem relativ spröden und harten Material, wie zum Beispiel keramische Beschichtungen, auf Schaufeln aus einem metallischen Werkstoff im Heißgasstrom eines Flugtriebwerks bei Erwärmung der Schaufel und bei dadurch bedingter Ausdehnung der metallischen Schaufeln schollenartig aufplatzen und die aufgeplatzten Schollen, zumindest sofern sich die Beschichtung in einem Kontaktbereich zu einem anderen Bauteil oder Bauteilabschnitt befindet, in relativ kurzer Zeit regelrecht aufgerieben werden. Verschiedene Beschichtungsverfahren sind aus den Druckschriften DE102011006294A1, DE3426201A1, JPS5698470A und DE69432642T2 bekannt. Ein Verfahren zur Herstellung eines Bauteils aus einem TiAl-Werkstoff ist aus der US2014369822 bekannt.

### OFFENBARUNG DER ERFINDUNG

### AUFGABE DER ERFINDUNG

Es ist deshalb Aufgabe der vorliegenden Erfindung ein Verfahren zur Beschichtung von Bauteilen sowie entsprechend hergestellte Bauteile mit einer Beschichtung bereitzustellen, bei denen die Haftfestigkeit der Beschichtung verbessert ist. Insbesondere soll das entsprechende Verfahren einfach und zuverlässig durchführbar sein und die Eigenschaften der Beschichtung und des Bauteils nicht oder nur geringfügig beeinträchtigen.

### TECHNISCHE LÖSUNG

Diese Aufgabe wird gelöst durch ein Verfahren mit den Merkmalen des Anspruchs 1 sowie einem Bauteil mit den Merkmalen des Anspruchs 10. Vorteilhafte Ausgestaltungen sind Gegenstand der abhängigen Ansprüche.

Die Erfindung schlägt vor, bei einem Bauteilgrundkörper, auf dem zumindest auf einem Teil der Oberfläche eine Beschichtung aufgebracht werden soll, zumindest einen Teil einer Randschicht des Bauteilgrundkörpers durch Wärmebehandlung so zu behandeln, dass ein Oberflächenbereich mit geändertem Eigenschaftsprofil entsteht, auf welchem anschließend die Beschichtung abgeschieden wird. Durch die Beeinflussung des Eigenschaftsprofils in einem Oberflächenbereich, und zwar vorzugsweise ausschließlich dort, wird einerseits das Eigenschaftsprofil des Bauteilgrundkörpers an sich nur vernachlässigbar beeinflusst, während an der Grenzfläche zwischen Bauteilgrundkörper und Beschichtung Eigenschaften des Bauteilgrundkörpers eingestellt werden können, die den Eigenschaften der Beschichtung angepasst sind, sodass die Haftung der Beschichtung auf dem Bauteilgrundkörper verbessert werden kann. Der Oberflächenbereich mit geändertem Eigenschaftsprofil wird demgemäß als eine Schicht an der Oberfläche des Bauteilgrundkörpers entsprechend der Randzone ausgebildet.

Das Eigenschaftsprofil des Oberflächenbereichs des Bauteilgrundkörpers wird so verändert, dass der Elastizitätsmodul und/oder die Härte der Randschicht des Bauteilgrundkörpers dem Elastizitätsmodul bzw. der Härte der Beschichtung angenähert wird, sodass der Unterschied der Dehnung, die der Oberflächenbereich des Bauteilgrundkörpers und die Beschichtung bei einer mechanischen Belastung erfahren, verringert werden kann. Eine sich ändernde mechanische Belastung kann zum Beispiel bei rotierenden Bauteilen einer Strömungsmaschine, wie zum Beispiel eine Laufschaufel oder eine rotierene Scheibe, dann auftreten, wenn das rotierende Bauteil eine Drehzahländerung erfährt.

Sofern die Beschichtung aus mehreren Teilschichten aufgebaut ist, wird durch die Oberflächenbehandlung einer Randschicht des Bauteilgrundkörpers die Annäherung des Eigenschaftsprofils an die an die Randschicht des Bauteilgrundkörpers angrenzende Teilschicht der Beschichtung durchgeführt.

Die Annäherung der Elastizitätsmoduli und/oder der Härten der Randschicht des Bauteilgrundkörpers und der Beschichtung beziehungsweise der an den Bauteilgrundkörper angrenzenden Teilschicht erfolgt so, dass auf die Elastizitätsmoduli und/oder Härten der Randschicht des Bauteilgrundkörpers und der angrenzenden Beschichtung bei Betriebstemperaturen des Bauteils abgestellt wird. Unter "abstellen" wird in diesem Zusammenhang insbesondere verstanden, dass die Werte sich angleichen, insbesondere im Wesentlichen identisch sind.

Da Korrosions-, Oxidations- und/oder Verschleißschutzschichten häufig aus keramischen Werkstoffen gebildet sind und die Bauteilgrundkörper üblicherweise aus metallischen Werkstoffen, wie metallischen Legierungen und/oder intermetallischen Verbindungen sowie Legierungen daraus, gebildet sind, wird zumindest ein Teil der Randschicht des Bauteilgrundkörpers durch die Wärmebehandlung einer Härtung unterzogen, um dadurch die mechanischen Eigenschaften von Randzone und Beschichtung anzunähern.

Die Härtung der Randschicht kann als Umwandlungshärtung und/oder Ausscheidungshärtung durchgeführt werden. In beiden Fällen wird durch die Wärmebehandlung eine Änderung der Mikrostruktur, also des Gefüges bewirkt, wobei durch die Gefügeänderung eine Härtung erzielt werden kann. Bei der Ausscheidungshärtung kommt es in Folge der Wärmebehandlung zur Ausscheidung von Partikeln im Gefüge, während bei der Umwandlungshärtung unterschiedliche Modifikationen des entsprechenden Werkstoffs bei der Gefügeausbildung mitwirken. Beispielsweise kann bei der schnellen Abschreckung eines Werkstoffes von einer Wärmebehandlungstemperatur, welcher bei der entsprechenden Wärmebehandlungstemperatur in einem Zweiphasengebiet des Phasendiagramms vorliegt, durch Einfrieren eines den Phasen bei der Wärmebehandlungstemperatur entsprechenden Zustands nach dem Abkühlen ein Härtungsgefüge ausgebildet werden. Das Härtungsgefüge, das durch die Härtung der Randzone erzeugt wird, gleicht die mechanischen Eigenschaften der Randzone des Bauteilgrundkörpers an die mechanischen Eigenschaften der Beschichtung an.

Die Wärmebehandlung der Randzone des Bauteilgrundkörpers, insbesondere zum Härten, kann mittels elektrischer Induktion oder energiereicher Strahlung, insbesondere Laserstrahlung erfolgen. Durch diese Arten der Erwärmung lässt sich eine schnelle und damit auf einen engen Randbereich begrenzte Erwärmung des Bauteilgrundkörpers verwirklichen.

Die Erwärmung der Randzone des Bauteilgrundkörpers kann unter Schutzgas oder im Vakuum stattfinden, um eine Beeinträchtigung des Bauteilgrundkörpers durch chemische Reaktionen, beispielsweise mit Sauerstoff, zu vermeiden. Alternativ kann auch eine definierte, oxidierende Atmosphäre während der Wärmebehandlung bzw. Erwärmung bereitgestellte werden, um beispielsweise durch Oxidieren der Randzone des Bauteilgrundkörpers eine weitere Möglichkeit der Änderung des Eigenschaftsprofils der Randzone und insbesondere eine Härtung der Randzone zu ermöglichen. Neben oxidierenden Atmosphären können auch Atmosphären bereitgestellt werden, mit deren Hilfe die Randzone bei der Oberflächenbehandlung nitriert, carbonitriert oder siliziert wird. Dadurch kann durch entsprechende Ausbildung von Nitriden, Carbonitriden, Oxiden oder Siliziden in der Randzone ebenfalls eine Eigenschaftsänderung und insbesondere eine Härtung bewirkt werden.

Ein entsprechend hergestelltes Bauteil weist somit unterhalb der Beschichtung im Bauteilgrundkörper eine Randzone auf, die ein Wärmebehandlungsgefüge, insbesondere ein Härtungsgefüge aufweist.

Die Beschichtung kann vorzugsweise eine nanoskalige Dünnschichtbeschichtung sein, die eine Dicke kleiner oder gleich 200 µm, insbesondere kleiner oder gleich 100 µm, bevorzug kleiner oder gleich 50 µm, aufweist. Versuche haben gezeigt, dass durch die Verwendung einer Dünnschicht mit einer derart geringen Dicke eine aus einem grundsätzlich relativ spröden Werkstoff, wie zum Beispiel einem keramischen Werkstoff, gebildete Schicht merklich duktilere Eigenschaften aufweist als eine dickere Schicht. Dies erleichtert es, die Härte der Randzone des Bauteilgrundkörpers der Härte des Schichtmaterials anzugleichen. Die Dünnschicht kann zum Beispiel mittels PVD hergestellt werden.

Die Beschichtung kann mehrschichtig ausgebildet sein und insbesondere eine Korrosionsschutzschicht und/oder Oxidationsschutzschicht und/oder eine Verschleißschutzschicht betreffen.

Der Bauteilgrundkörper ist aus einem TiAl - Werkstoff gebildet, wobei das Wärmebehandlungsgefüge im behandelten Oberflächenbereich des Bauteilgrundkörper einen geringeren Anteil an γ - TiAl aufweist als der restliche Bauteilgrundkörper. Der γ - TiAl - Anteil trägt stark zur Duktilität des Werkstoffs bei. Durch die Wärmebehandlung und das schnelle Abschrecken kann der Anteil an γ - TiAl in der Randzone gegenüber dem restlichen Bauteilgrundkörper reduziert werden, so dass die Randzone entsprechend härter wird und somit an die Materialeigenschaften der Beschichtung angeglichen werden kann.

Insbesondere kann das Wärmebehandlungsgefüge im behandelten Oberflächenbereich des Bauteilgrundkörpers einen Anteil an γ - TiAl von weniger als 5% aufweist, wohingegen der restliche Bauteilgrundkörper einen Anteil an γ - TiAl von mehr als 5% aufweist, vorzugsweise zwischen 5% und 15%.

Besonders vorteilhaft wird das erfindungsgemäße Verfahren auf Bauteile bzw. Bauteilabschnitte angewendet, die im bestimmungsgemäßen Betrieb der Strömungsmaschine als Kontaktstellen zu anderen Bauteilen bzw. Bauteilabschnitten fungieren und somit besonders verschleißgefährdet sind. Insbesondere kann das erfindungsgemäße Verfahren im Bereich der Schaufelfussflanken und/oder der so genannten Z-Notches am Außendeckband von Laufschaufeln angewendet werden.

### KURZBESCHREIBUNG DER ZEICHNUNGEN

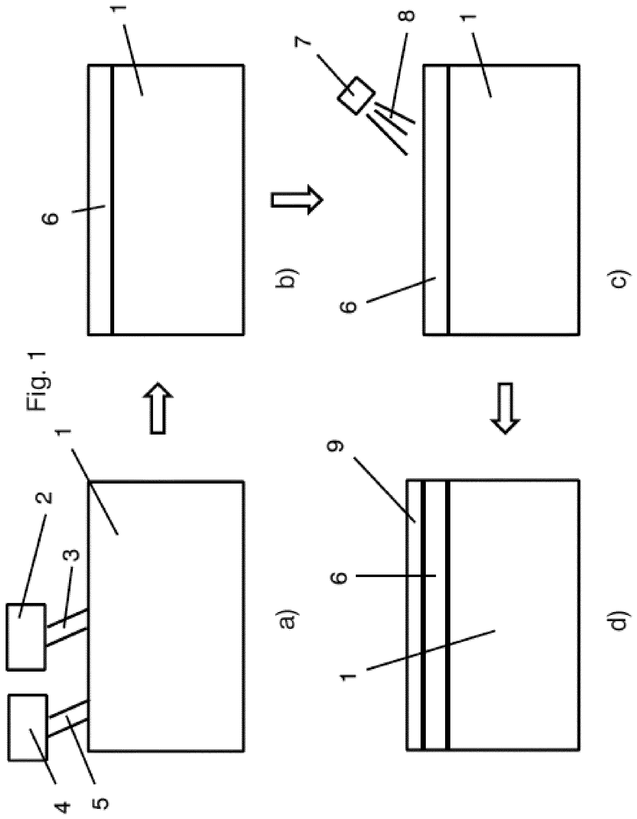

Die beigefügten Zeichnungen zeigen in rein schematischer Weise in
- Fig. 1: in den Teilbildern a) bis d) die verschiedenen Stadien der Herstellung eines erfindungsgemäßen Bauteils.

### AUSFÜHRUNGSBEISPIELE

Weitere Vorteile, Kennzeichen und Merkmale der vorliegenden Erfindung werden bei der nachfolgenden detaillierten Beschreibung von Ausführungsbeispielen deutlich, wobei die Erfindung allerdings nicht auf diese Ausführungsbeispiele beschränkt ist.

Die Figur 1 zeigt in den Teilbildern in a) bis d) die verschiedenen Stadien der erfindungsgemäßen Herstellung eines beschichteten Bauteils. Zur Herstellung des beschichteten Bauteils wird zunächst ein Bauteilgrundkörper 1 bereitgestellt, wie beispielsweise eine Turbinenschaufel oder dergleichen, welches zumindest teilweise, zum Beispiel im Bereich des Schaufelfußes oder der so genannten Z-Notches am Außendeckband, eine Beschichtung 9 erhalten soll, wie beispielsweise eine Korrosionsschutzschicht, eine Oxidationsschutzschicht und/oder eine Verschleißschutzschicht.

Die zu beschichtende Bauteiloberfläche des Bauteilgrundkörpers 1 wird bei dem gezeigten Ausführungsbeispiel der Figur 1 zunächst gemäß Teilbild a) mit einem hochenergetischen Strahl 3 bearbeitet, der beispielsweise von einer Laserquelle 2 stammt. Der Laserstrahl 3 wird dabei so über die Bauteiloberfläche des Bauteilgrundkörpers 1 geführt, dass der gesamte zu bearbeitende Oberflächenbereich, der beispielsweise mit dem Beschichtungsbereich übereinstimmt, mit dem Laserstrahl 3 bearbeitet wird. Durch das Auftreffen des Laserstrahls 3 wird das oberflächennahe Material des Bauteilgrundkörpers 1 erwärmt und zwar insbesondere auf eine Temperatur, die eine Phasenumwandlung des oberflächennahen Materials des Bauteilgrundkörpers 1 bewirkt.

Bei der aufgrund der erzeugten Temperatur bewirkten Phasenumwandlung im oberflächennahen Bereich des Bauteilgrundkörpers 1 kann durch nachfolgendes schnelles Abkühlen, vorzugsweise bei einer Abkühlrate von 200K bis 400K pro Minute, der Randzone des Bauteilgrundkörpers 1 eine Rückumwandlung gemäß dem Gleichgewichtsphasendiagramm verhindert wird, sodass ein Zustand eingefroren wird, der der Randzone des Bauteilgrundkörpers ein anderes Eigenschaftsprofil und insbesondere eine veränderte Härte sowie Elastizität verleiht.

Bei dem Werkstoff des Bauteilgrundkörpers kann es sich insbesondere um einen TiAl - Werkstoff handeln, da TiAl - Werkstoffe in Strömungsmaschinen, wie Flugtriebwerken, beispielsweise für Schaufeln eingesetzt werden, die zusätzlich mit Oxidationsschutz - oder Verschleißschutzschichten versehen sein können.

Der TiAl - Werkstoff kann zum Beispiel einen Aluminiumanteil zwischen 30 at.% und 40 at.% aufweisen. Wird das oberflächennahe Gefüge durch die Bearbeitung mit dem Laserstrahl auf eine Temperatur oberhalb der so genannten α - Transus - Temperatur erhöht, reduziert sich der γ - TiAl - Anteil und erhöht sich der α - Ti - Anteil im Gefüge der Randzone gegenüber dem restlichen Bauteilgrundkörper. Bei einer langsamen Abkühlung würde eine Rückumwandlung des Gefüges durch Diffusion erfolgen, so dass das Gefüge der Randzone im Wesentlichen wieder dem Gefüge des restlichen Bauteilgrundkörpers entsprechen würde. Wird jedoch die Abkühlung schnell durchgeführt, so dass die erforderlichen Diffusionsprozesse nicht stattfinden können, können die Konzentrationsunterschiede zwischen dem α -Ti und dem γ - TiAl nicht ausgeglichen werden. Somit weist das Gefüge des TiAl - Werkstoffs im abgekühlten Zustand einen gegenüber dem Gleichgewichtszustand verringerten γ - TiAl - Bestandteil auf. Ein derartiges Gefüge besitzt jedoch eine geringere Dehnung und somit einen höheren Elastizitätsmodul sowie eine höhere Härte verglichen mit einem γ - TiAl im thermodynamischen Gleichgewicht. Insbesondere kann der Bauteilgrundkörper, z.B. eine Laufschaufel einer Fluggasturbine, auf diese Weise derart wärmebehandelt werden, dass seine wärmehandelte Randzone einen γ - TiAl - Anteil von unter 5% aufweist, wohingegen der restliche Bauteilgrundkörper einen γ - TiAl - Anteil von über 5% aufweist, vorzugsweise einen γ - TiAl - Anteil zwischen 5% und 15%.

Eine derartige als Umwandlungshärtung bezeichnete Vorgehensweise zur Änderung der mechanischen Eigenschaften der Randzone ist bei vielen verschiedenen Werkstoffen, die bei Strömungsmaschinen für unterschiedliche Bauteile eingesetzt werden, möglich, sodass das System TiAl lediglich als Beispiel zur Verdeutlichung dient, aber die Erfindung auch mit anderen Werkstoffen für den Bauteilgrundkörper verwirklicht werden kann.

Entsprechend wird bei dem erfindungsgemäßen Verfahren, welches anhand eines Ausführungsbeispiels in Figur 1 dargestellt ist, nach der Oberflächenbehandlung mit dem Laserstrahl 3 eine Abkühlung vorgenommen, beispielsweise mittels eines Gebläses 4, welches eine Kühlluftstrom 5 auf den erwärmten Oberflächenbereich des Bauteilgrundkörpers 1 lenkt, sodass eine ausreichend schnelle Abkühlung der Randzone des Bauteilgrundkörpers 1 erfolgt.

Dadurch entsteht ein Bauteilgrundkörper 1 mit einer gehärteten Randzone 6 wie in Teilbild b) dargestellt ist.

Auf einen derart vorbereiteten Bauteilgrundkörper 1 wird gemäß der Erfindung, wie in Teilbild c) gezeigt ist, eine Beschichtung abgeschieden, wobei unterschiedliche Beschichtungsverfahren zum Einsatz kommen können, wie beispielsweise physikalische Dampfphasenabscheidung (physical vapour deposition PVD), insbesondere Sputtern, oder chemische Dampfphasenabscheidungsverfahren (chemical vapour deposition CVD). Dabei wird bevorzugt eine sehr dünne Schicht abgeschieden, d.h. eine Schicht mit einer Dicke ≤ 200 µm, insbesondere ≤ 100 µm, bevorzugt ≤ 50 µm. Eine solche Dünnschicht weist nämlich - wie Versuche gezeigt haben - duktilere Eigenschaften auf, als eine dickere Schicht aus demselben Material.

Die Figur 1 zeigt im Teilbild c) in rein schematischer Weise eine Beschichtungsquelle 7 und einen Strahl mit Beschichtungsmaterial 8, welcher auf der gehärtete Randzone 6 des Bauteilgrundkörpers 1 abgeschieden wird. Dadurch wird eine Beschichtung 9 erzeugt, die auf der gehärteten Randzone 6 des Bauteilgrundkörpers 1 abgeschieden ist. Durch die gehärtete Randzone 6 ist das Eigenschaftsprofil des Werkstoffs des Bauteilgrundkörpers 1 an der Oberfläche geändert und zwar insbesondere angepasst an das Eigenschaftsprofil der Beschichtung 9, vor allem hinsichtlich der mechanischen Eigenschaften. So können durch die Oberflächenbehandlung mittels Erwärmen und Abkühlen der Randzone des Bauteilgrundkörpers 1 eine höhere Härte und geringere Dehnbarkeit, also insbesondere ein größerer Elastizitätsmodul in der Randzone 6 eingestellt werden, der den mechanischen Eigenschaften der Beschichtung 9 angepasst ist, also dem Elastizitätsmodul der Beschichtung 9 insbesondere bei der vorgesehenen Betriebstemperatur für das Bauteil angenähert ist. Dadurch kommt es bei mechanischer Belastung beim Betrieb des Bauteils zu geringeren Unterschieden hinsichtlich der Dehnung, sodass Probleme hinsichtlich der Haftfestigkeit vermieden werden können.

Obwohl die vorliegende Erfindung anhand der Ausführungsbeispiele deutlich beschrieben worden ist, ist für den Fachmann selbstverständlich, dass die Erfindung nicht auf diese Ausführungsbeispiele beschränkt ist, sondern dass vielmehr Abwandlungen in der Weise möglich sind, dass einzelne Merkmale weggelassen oder andersartige Kombinationen von Merkmalen verwirklicht werden können, solange der Schutzbereich der beigefügten Ansprüche nicht verlassen wird. Die vorliegende Offenbarung schließt sämtliche Kombinationen der vorgestellten Einzelmerkmale mit ein.

## Patentansprüche

1. Verfahren zur Herstellung eines Bauteils mit einer Beschichtung (9), wobei das Bauteil einen Bauteilgrundkörper (1) und eine auf dem Bauteilgrundkörper aufgebrachte Beschichtung (9) umfasst und wobei bei dem Verfahren zunächst zumindest ein Teil einer Randschicht des Bauteilgrundkörpers durch Wärmebehandlung so behandelt, nämlich gehärtet, wird, dass ein Oberflächenbereich (6) mit geändertem Eigenschaftsprofil entsteht, und anschließend die Beschichtung (9) auf dem Oberflächenbereich (6) mit geändertem Eigenschaftsprofil abgeschieden wird,
wobei die Randschicht so behandelt wird, dass der Elastizitätsmodul und/oder die Härte des geänderten Oberflächenbereichs (6) dem Elastizitätsmodul bzw. der Härte der Beschichtung (9) angenähert wird, wobei die Elastizitätsmoduli bzw. die Härten bei der Betriebstemperatur des Bauteils verwendet werden,
wobei der Bauteilgrundkörper aus einem TiAl-Werkstoff gebildet ist, wobei das Wärmebehandlungsgefüge im behandelten Oberflächenbereich (6) des Bauteilgrundkörpers (1) einen geringeren Anteil an γ - TiAl aufweist als der restliche Bauteilgrundkörper (1),
und wobei die Beschichtung (9) eine Korrosionsschutzschicht und/oder eine Oxidationsschutzschicht und/oder eine Verschleißschutzschicht ist, welche aus einem keramischen Werkstoff gebildet ist.

2. Verfahren nach einem der vorhergehenden Ansprüche,
**dadurch gekennzeichnet, dass**
das Bauteil eine Laufschaufel einer Strömungsmaschine ist, wobei das Verfahren im Bereich von Schaufelfussflanken und/oder von Z-Notches an einem Außendeckband der Laufschaufel angewendet wird.

3. Verfahren nach einem der vorhergehenden Ansprüche,
**dadurch gekennzeichnet, dass**
die Beschichtung (9) mehrschichtig ausgebildet ist, wobei durch die Oberflächenbehandlung der Randschicht des Bauteilgrundkörpers (1) die Annährung des Eigenschaftsprofils an die an die Randschicht des Bauteilgrundkörpers (1) angrenzende Teilschicht der Beschichtung (9) erreicht wird, so dass die Elastizitätsmoduli und/oder Härten der Randschicht des Bauteilgrundkörpers (1) und der angrenzenden Teilschicht der Beschichtung (9) im Wesentlichen identisch sind.

4. Verfahren nach einem der vorhergehenden Ansprüche,
**dadurch gekennzeichnet, dass**
die Härtung der Randschicht als eine Umwandlungshärtung und/oder Ausscheidungshärtung durchgeführt wird.

5. Verfahren nach einem der vorhergehenden Ansprüche,
**dadurch gekennzeichnet, dass**
die Härtung der Randzone mittels einer Randzonenerwärmung und schnellem Abschrecken erfolgt, mit einer Abkühlgeschwindigkeit zwischen 200°K und 400°K pro Minute.

6. Verfahren nach einem der vorhergehenden Ansprüche,
**dadurch gekennzeichnet, dass**
eine Erwärmung der Randzone des Bauteilgrundkörpers (1) zum Härten mittels Induktion oder energiereicher Bestrahlung, insbesondere Laserbestrahlung, erfolgt.

7. Verfahren nach einem der vorhergehenden Ansprüche,
**dadurch gekennzeichnet, dass**
eine Erwärmung der Randzone des Bauteilgrundkörpers (1) zum Härten unter Schutzgas oder im Vakuum oder in einem härtenden Medium erfolgt.

8. Verfahren nach einem der vorhergehenden Ansprüche,
**dadurch gekennzeichnet, dass**
mindestens ein Teil der Randzone des Bauteilgrundkörpers (1) einer Oberflächenbehandlung durch Nitrieren, Carbonitrierern, Oxidieren oder Silizieren unterzogen wird.

9. Verfahren nach einem der vorhergehenden Ansprüche,
**dadurch gekennzeichnet, dass**
die Beschichtung (9) als nanoskalige Dünnschicht mit einer Dicke ≤ 200 µm, insbesondere ≤ 100 µm, bevorzugt ≤ 50 µm, aufgebracht wird.

10. Bauteil, hergestellt mit einem Verfahren nach einem der vorhergehenden Ansprüche, mit einem Bauteilgrundkörper (1) und mit einer Beschichtung (9) auf zumindest einem Teil des Bauteilgrundkörpers (1), wobei ein Oberflächenbereich des Bauteilgrundkörpers (1) ein Wärmebehandlungsgefüge, nämlich ein Härtungsgefüge, aufweist,
wobei die Randschicht so behandelt ist, dass das geänderte Eigenschaftsprofil des Oberflächenbereichs (6) umfasst, dass der Elastizitätsmodul und/oder die Härte des geänderten Oberflächenbereichs (6) dem Elastizitätsmodul bzw. der Härte der Beschichtung (9) angenähert ist, wobei die Elastizitätsmoduli bzw. die Härten bei der Betriebstemperatur des Bauteils verwendet werden,
wobei der Bauteilgrundkörper (1) aus einem TiAl-Werkstoff gebildet ist, wobei das Wärmebehandlungsgefüge im behandelten Oberflächenbereich (6) des Bauteilgrundkörpers (1) einen geringeren Anteil an y - TiAl aufweist als der restliche Bauteilgrundkörper (1),
und wobei die Beschichtung (9) eine Korrosionsschutzschicht und/oder eine Oxidationsschutzschicht und/oder eine Verschleißschutzschicht ist, welche aus einem keramischen Werkstoff gebildet ist.

11. Bauteil nach Anspruch 10,
**dadurch gekennzeichnet, dass**
das Wärmebehandlungsgefüge im behandelten Oberflächenbereich des Bauteilgrundkörpers (1) einen Anteil an γ - TiAl von weniger als 5% aufweist, wohingegen der restliche Bauteilgrundkörper (1) einen Anteil an γ - TiAl von mehr als 5% aufweist, vorzugsweise zwischen 5% und 15%.

## Claims

1. Method for producing a component having a coating (9), wherein the component comprises a component main body (1) and a coating (9) applied to the component main body and wherein, in the method, initially at least part of a surface layer of the component main body is treated by heat treatment, in particular hardened, such that a surface region (6) is created that has an altered property profile, and the coating (9) is subsequently deposited on the surface region (6) having an altered property profile, wherein the surface layer is treated such that the modulus of elasticity and/or the hardness of the altered surface region (6) approximates the modulus of elasticity or the hardness of the coating (9), wherein the moduli of elasticity and/or the hardnesses are used at the operating temperature of the component, wherein the component main body is made of a TiAl material, wherein the heat treatment structure has a smaller proportion of y - TiAl in the treated surface region (6) of the component main body (1) than the remaining component main body (1), and wherein the coating (9) is a corrosion-protection layer and/or an oxidation-protection layer and/or a wear-protection layer, made of a ceramic material.

2. Method according to any of the preceding claims, **characterized in that** the component is a rotor blade of a turbomachine, the method being applied in the region of blade root flanks and/or Z-notches at an outer shroud of the rotor blade.

3. Method according to any of the preceding claims, **characterized in that** the coating (9) is multi-layered, the surface treatment of the surface layer of the component main body (1) resulting in the approximation of the property profile to the sublayer of the coating (9) adjacent to the surface layer of the component main body (1) such that the moduli of elasticity and/or hardnesses of the surface layer of the component main body (1) and of the adjacent sublayer of the coating (9) are substantially identical.

4. Method according to any of the preceding claims, **characterized in that** the hardening of the surface layer takes place by transformation hardening and/or precipitation hardening.

5. Method according to any of the preceding claims, **characterized in that** the hardening of the surface zone takes place by means of surface zone heating and rapid quenching, at a cooling rate between 200 °K and 400 °K per minute.

6. Method according to any of the preceding claims, **characterized in that,** for hardening, heating of the surface zone of the component main body (1) takes place by means of induction or high-energy irradiation, in particular laser irradiation.

7. Method according to any of the preceding claims, **characterized in that,** for hardening, heating of the surface zone of the component main body (1) takes place using protective gas or in a vacuum or in a hardening medium.

8. Method according to any of the preceding claims, **characterized in that** at least part of the surface zone of the component main body (1) undergoes a surface treatment by nitridation, carbon nitridation, oxidization or siliconization.

9. Method according to any of the preceding claims, **characterized in that** the coating (9) is applied as a nanoscale thin layer having a thickness of ≤ 200 µm, in particular ≤ 100 µm, preferably ≤ 50 µm.

10. Component produced using a method according to any of the preceding claims, comprising a component main body (1) and a coating (9) on at least part of the component main body (1), wherein a surface region of the component main body (1) has a heat treatment structure, in particular a hardening structure, wherein the surface layer is treated such that it comprises the altered property profile of the surface region (6), such that the modulus of elasticity and/or the hardness of the altered surface region (6) approximates the modulus of elasticity or the hardness of the coating (9), wherein the moduli of elasticity and/or the hardnesses are used at the operating temperature of the component, wherein the component main body (1) is made of a TiAl material, wherein the heat treatment structure has a smaller proportion of y - TiAl in the treated surface region (6) of the component main body (1) than the remaining component main body (1), and wherein the coating (9) is a corrosion-protection layer and/or an oxidation-protection layer and/or a wear-protection layer, made of a ceramic material.

11. Component according to claim 10, **characterized in that** the heat treatment structure has a proportion of y - TiAl of less than 5% in the treated surface region of the component main body (1), whereas the remaining component main body (1) has a proportion of y - TiAl of more than 5%, preferably between 5% and 15%.

## Revendications

1. Procédé de fabrication d'un composant doté d'un revêtement (9), dans lequel le composant comprend un corps de base de composant (1) et un revêtement (9) appliqué sur le corps de base de composant et dans lequel au moins une partie d'une couche périphérique du corps de base de composant subit d'abord, lors du procédé, un traitement thermique, à savoir est durcie, de sorte à produire une zone superficielle (6) ayant un profil de propriétés modifié, puis le revêtement (9) est déposé sur la zone superficielle (6) ayant un profil de propriétés modifié,
la couche périphérique étant traitée de sorte que le module d'élasticité et/ou la dureté de la zone superficielle (6) modifiée s'approche du module d'élasticité ou de la dureté du revêtement (9), les modules d'élasticité ou les duretés étant utilisées à la température de fonctionnement du composant,
le corps de base de composant étant formé d'un matériau constitué de TiAI, la structure de traitement thermique comportant, dans la zone superficielle (6) traitée du corps de base de composant (1), une proportion de γ - TiAl inférieure au reste du corps de base de composant (1), et le revêtement (9) étant une couche de protection contre la corrosion et/ou une couche de protection contre l'oxydation et/ou une couche de protection contre l'usure, qui est constituée d'un matériau céramique.

2. Procédé selon l'une des revendications précédentes,
**caractérisé en ce que**
le composant est une aube de turbomachine, le procédé étant appliqué au niveau des flancs du pied d'aube et/ou des rainures en Z sur un carénage extérieur de l'aube.

3. Procédé selon l'une des revendications précédentes,
**caractérisé en ce que**
le revêtement (9) est formé de plusieurs couches, le traitement de surface de la couche périphérique du corps de base de composant (1) permettant le rapprochement du profil de propriétés avec la couche partielle du revêtement (9) adjacente à la couche périphérique du corps de base de composant (1), de sorte que les modules d'élasticité et/ou les duretés de la couche périphérique du corps de base de composant (1) et de la couche partielle adjacente du revêtement (9) sont sensiblement identiques.

4. Procédé selon l'une des revendications précédentes,
**caractérisé en ce que**
le durcissement de la couche périphérique est exécuté par durcissement par trempe et/ou durcissement par précipitation.

5. Procédé selon l'une des revendications précédentes,
**caractérisé en ce que**
le durcissement de la zone périphérique est réalisé au moyen d'un chauffage de la zone périphérique et d'un trempage rapide, avec une vitesse de refroidissement comprise entre 200°K et 400°K par minute.

6. Procédé selon l'une des revendications précédentes,
**caractérisé en ce que**
la zone périphérique du corps de base de composant (1) est chauffée afin d'être durcie par induction ou par rayonnement à haute énergie, en particulier par rayonnement laser.

7. Procédé selon l'une des revendications précédentes,
**caractérisé en ce que**
la zone périphérique du corps de base de composant (1) est chauffée afin d'être durcie sous gaz de protection ou sous vide ou dans un milieu durcissant.

8. Procédé selon l'une des revendications précédentes,
**caractérisé en ce**
**qu**'au moins une partie de la zone périphérique du corps de base de composant (1) est soumise à un traitement de surface par nitruration, carbonitruration, oxydation ou enrichissement en silicium.

9. Procédé selon l'une des revendications précédentes,
**caractérisé en ce que**
le revêtement (9) est appliqué sous forme de film mince nanoscopique ayant une épaisseur ≤ 200 µm, en particulier ≤ 100 µm, de préférence ≤ 50 µm.

10. Composant, fabriqué à l'aide d'un procédé selon l'une des revendications précédentes, doté d'un corps de base de composant (1) et d'un revêtement (9) sur au moins une partie du corps de base de composant (1), dans lequel une zone superficielle du corps de base de composant (1) comporte une structure de traitement thermique, à savoir une structure de durcissement,
la couche périphérique étant traitée de sorte que le profil de propriétés modifié de la zone superficielle (6) comprend le fait que le module d'élasticité et/ou la dureté de la zone superficielle (6) modifiée s'approche du module d'élasticité ou de la dureté du revêtement (9), les modules d'élasticité ou les duretés étant utilisés à la température de fonctionnement du composant,
le corps de base de composant (1) étant formé d'un matériau constitué de TiAI, la structure de traitement thermique comportant, dans la zone superficielle (6) traitée du corps de base de composant (1), une proportion de γ - TiAl inférieure au reste du corps de base de composant (1), et le revêtement (9) étant une couche de protection contre la corrosion et/ou une couche de protection contre l'oxydation et/ou une couche de protection contre l'usure, qui est constituée d'un matériau céramique.

11. Composant selon la revendication 10,
**caractérisé en ce que**
la structure de traitement thermique dans la zone superficielle traitée du corps de base de composant (1) présente une proportion de γ - TiAl inférieure à 5 %, alors que le reste du corps de base de composant (1) présente une proportion de γ - TiAl supérieure à 5 %, comprise de préférence entre 5 % et 15 %.
